Europäisches Patentamt

European Patent Office

Office européen des brevets

(11) Numéro de publication : **0 465 334 B1**

(12)

# FASCICULE DE BREVET EUROPEEN

(45) Date de publication du fascicule du brevet :
**15.03.95 Bulletin 95/11**

(51) Int. Cl.⁶ : **H03H 17/02, G01P 3/48**

(21) Numéro de dépôt : **91401793.4**

(22) Date de dépôt : **01.07.91**

(54) **Dispositif et procédé de filtrage de signaux électriques notamment pour la commande de logomètres.**

(30) Priorité : **02.07.90 FR 9008334**

(43) Date de publication de la demande :
**08.01.92 Bulletin 92/02**

(45) Mention de la délivrance du brevet :
**15.03.95 Bulletin 95/11**

(84) Etats contractants désignés :
**DE ES GB IT**

(56) Documents cités :
**PATENT ABSTRACTS OF JAPAN vol. 10, no.
215 (P-481)26 Juillet 1986 & JP-A-61 054 456
(TOYODA ) 18 Mars 1986
ELECTRONICS LETTERS vol. 19, no. 2, 20
Janvier 1983, LONDON GB pages 55 -
57;CRAWFORD: 'structure of spatio-temporal
prefilters for conditionalreplenishment video coders '**

(73) Titulaire : **MARELLI AUTRONICA**
**19 Rue Lavoisier**
**F-92000 Nanterre (FR)**

(72) Inventeur : **Granjoux, Michel**
**17 rue de Paris**
**F-92190 Meudon (FR)**
Inventeur : **Thuillier, Marc**
**3 bis avenue Paul Vaillant Couturier**
**F-91390 Morsans S/Orge (FR)**

(74) Mandataire : **Martin, Jean-Jacques et al**
**Cabinet REGIMBEAU**
**26, Avenue Kléber**
**F-75116 Paris (FR)**

## Description

La présente invention concerne le domaine des dispositifs et procédés de filtrage de signaux électriques.

La présente invention trouve notamment application dans le filtrage des signaux électriques appliqués aux logomètres utilisés sur véhicules automobiles, par exemple les compte-tours et compteurs de vitesse.

Les logomètres comprennent généralement plusieurs bobines croisées, le plus souvent deux bobines croisées à 90°, un axe guidé à rotation, un aimant solidaire de l'axe placé à l'intérieur des bobines, une aiguille indicatrice externe aux bobines et solidaire de l'axe, et des moyens de commande appliquant des signaux électriques appropriés aux bobines.

Les logomètres comprennent également parfois une coupelle fixe contenant un liquide d'amortissement, dans lequel baigne l'aimant.

Chacune des bobines génère un champ magnétique proportionnel au courant qui la traverse. L'aimant se positionne selon la résultante de ces champs. Pour un logomètre à deux bobines, l'angle défini par l'aiguille indicatrice, par rapport à une position d'origine est donc déterminé par la relation $\tan^{-1}$ $I1/I2$, dans laquelle $I1$ et $I2$ représentent une valeur proportionnelle aux ampères - tours circulant respectivement dans les bobines.

Si des précautions ne sont pas prises pour filtrer les signaux électriques appliqués aux logomètres, on constate fréquemment des oscillations néfastes et désagréables de l'aiguille indicatrice.

Différents dispositifs de filtrage ont déjà été proposés pour éliminer cet inconvénient.

Le document EP-A-218737 décrit par exemple un dispositif comprenant essentiellement un filtre du second ordre.

Le document JP-61054456 enseigne un procédé de filtrage d'un signal électrique, en particulier d'un signal de vitesse mesuré sur un véhicule automobile, comportant les étapes consistant à :
- comparer chaque nouvelle valeur (P2) reçue d'un signal d'entrée à une valeur d'entrée antérieure (P1),
- comparer l'écart (Pc) détecté entre ladite nouvelle valeur reçue (P2) du signal d'entrée et la valeur d'entrée antérieure (P1), avec une valeur seuil prédéterminée (DELTA P),
- mémoriser la valeur d'entrée antérieure en tant que valeur de consigne,
- rafraîchir la valeur représentant la valeur de consigne de la manière suivante :
  . si la valeur de seuil prédéterminée (DELTA P) est supérieure audit écart détecté, (Pc), la valeur de consigne (P3) est choisie égale à la nouvelle valeur d'entrée (P2),
  . si la valeur de seuil prédéterminée (DELTA P) est inférieure audit écart détecté, (Pc), la valeur de consigne (P3) est choisie égale à la valeur d'entrée antérieure +/- la valeur de seuil prédéterminée (DELTA P), et
- multiplier la valeur représentant la valeur de consigne par une constante pour former le signal de sortie.

La présente invention a maintenant pour but de proposer un nouveau dispositif et un nouveau procédé de filtrage perfectionné.

Le procédé de filtrage conforme à la présente invention comprend les étapes consistant à :
- comparer chaque nouvelle valeur reçue d'un signal d'entrée avec une valeur de comparaison antérieure,
- comparer l'écart détecté entre, ladite nouvelle valeur reçue du signal d'entrée et la valeur de comparaison antérieure avec une valeur seuil prédéterminée,
- mémoriser une valeur de consigne,
- rafraîchir la valeur de consigne mémorisée en modifiant la valeur de consigne antérieure de la valeur seuil prédéterminée si ladite valeur seuil prédéterminée est inférieure audit écart détecté, ou en modifiant la valeur de consigne antérieure dudit écart détecté, si ladite valeur seuil prédéterminée est supérieure audit écart détecté, et
- diviser la valeur de consigne mémoriser par une constante pour former le signal de sortie, et le procédé conforme à la présente invention est caractérisé par le fait que la valeur de comparaison antérieure est égale à la valeur du signal de sortie antérieur.

Le dispositif de filtrage conforme à la présente invention comprend :
- des moyens aptes à comparer chaque nouvelle valeur reçue d'un signal d'entrée, à une valeur de comparaison antérieure,
- des moyens aptes à comparer l'écart détecté entre ladite nouvelle valeur reçue du signal d'entrée et la valeur de comparaison antérieure, avec une valeur seuil prédéterminée,
- des moyens de mémoire aptes à mémoriser une valeur de consigne,
- des moyens aptes à rafraîchir la valeur de consigne mémorisée
  . en modifiant la valeur consigne antérieure de la valeur seuil prédéterminée, si ladite valeur seuil prédéterminée est inférieure audit écart détecté, ou
  . en modifiant la valeur de consigne antérieure dudit écart détecté, si ladite valeur seuil prédéterminée est supérieure audit écart détecté, et
- des moyens aptes à diviser la valeur de consigne mémorisée par une constante pour former le signal de sortie, et ce dispositif est caractérisé par le fait que la valeur de comparaison antérieure est égale à la valeur du signal de sortie antérieure.

Selon une autre caractéristique avantageuse de la présente invention, le dispositif comprend des moyens aptes à reconnaître le sens de l'écart détecté entre ladite nouvelle valeur reçue du signal d'entrée et la valeur de sortie antérieure.

D'autres caractéristiques, buts et avantages de la présente invention apparaîtront à la lecture de la description détaillée qui va suivre et en regard des dessins annexés donnés à titre d'exemple non limitatif et sur lesquels :

- la figure 1 représente schématiquement sous forme de bloc fonctionnel un circuit de traitement de signal pour la commande de logomètres, dans lequel peut trouver application le dispositif de filtrage conforme à la présente invention,
- la figure 2 représente sous forme d'organigramme schématique le procédé de filtrage conforme à la présente invention, et
- la figure 3 représente schématiquement sous forme de bloc fonctionnel un dispositif de filtrage conforme à la présente invention.

Le dispositif de filtrage conforme à la présente invention peut faire l'objet de nombreuses applications.

Toutefois, comme indiqué précédemment, la présente invention trouve tout particulièrement application dans le filtrage des signaux électriques appliqués aux logomètres utilisés sur véhicules automobiles.

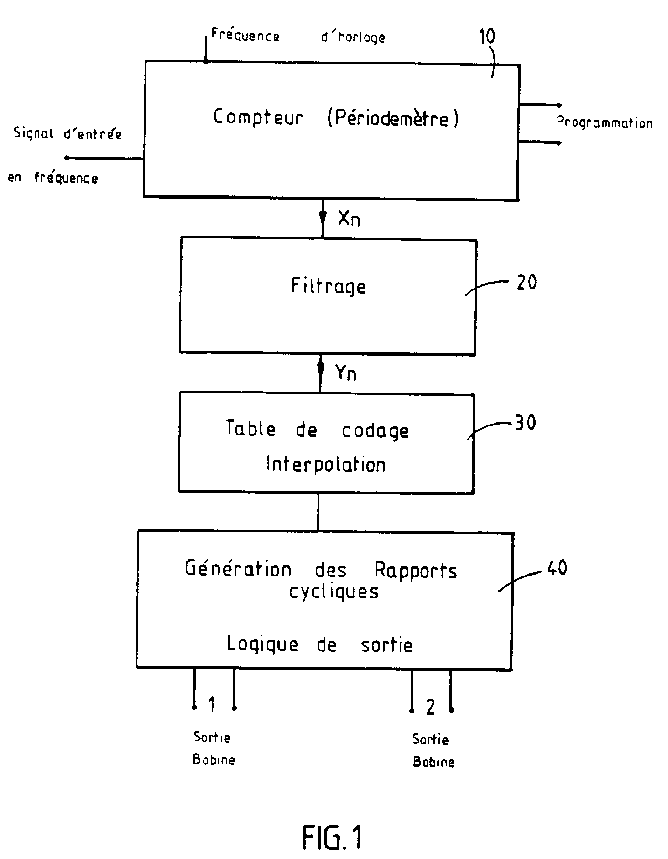

Dans ce contexte le dispositif de filtrage conforme à la présente invention peut préférentiellement être inséré dans un circuit de traitement de signal comprenant comme représenté sur la figure 1 annexée un périodemètre 10 suivi du dispositif de filtrage 20, d'une table de codage et d'interpolation 30 et d'un module 40 de génération des rapports cycliques des signaux de commande appliqués sur les deux bobines du logomètre.

La structure générale du circuit de traitement précité est représentée sur la figure 1 et décrite par exemple dans la demande de brevet français déposée le 19 Décembre 1988 sous le n° 88 16759 et publiée sous le n° 2 640 744. La structure du circuit de traitement représenté sur la figure 1, dans lequel la présente invention trouve application ne sera donc pas décrite en détail par la suite.

On va toutefois rappeler succinctement la structure du circuit de traitement représenté sur la figure 1.

Ce circuit a pour but de mettre en forme un signal d'entrée en fréquence, c'est-à-dire un signal dont la fréquence est proportionnelle aux paramètres à visualiser sur logomètre.

Pour cela le périodemètre 10 comprend essentiellement un compteur apte à compter les périodes d'un signal d'horloge de fréquence fixe entre deux fronts identiques, par exemple deux fronts montants du signal d'entrée. De préférence le compteur du périodemètre est suivi d'un diviseur programmable.

Ainsi, on obtient en sortie du périodemètre 10 un signal numérique qui est proportionnel à la fréquence du signal d'entrée et à l'angle de déviation recherché du logomètre.

Le signal de sortie du périodemètre est référencé Xn sur la figure 1. Ce signal Xn est appliqué à l'entrée du dispositif de filtrage conforme à la présente invention.

Le signal de sortie du dispositif de filtrage est référencé Yn. Ce signal Yn est appliqué à une table de codage et d'interpolation 30.

Plus précisément, pour un affichage pleine échelle sur 360° les deux bits de poids le plus fort du signal Yn servent à coder le cadran d'affichage.

Les bits de poids intermédiaires du signal Yn vont servir à adresser une table de codage intégré au module 30 et contenant des valeurs de sinus et cosinus aptes à piloter le logomètre. Les bits de poids le plus faible du signal Yn servent à piloter un interpolateur afin d'affiner la valeur des signaux de commande en sinus cosinus compris entre les valeurs de bits de poids intermédiaires utilisés. Cette disposition permet d'utiliser une table de codage 30 de faible capacité.

Les modules 40 déterminent ensuite les rapports cycliques de signaux appliqués aux deux bobines du logomètre, de sorte que la durée au niveau haut des signaux logiques appliqués aux bobines soit proportionnelle aux sinus et cosinus respectivement de l'angle de déviation recherché.

On se référera utilement à la demande de brevet n° 88 16758 précitée pour la bonne compréhension de la présente invention.

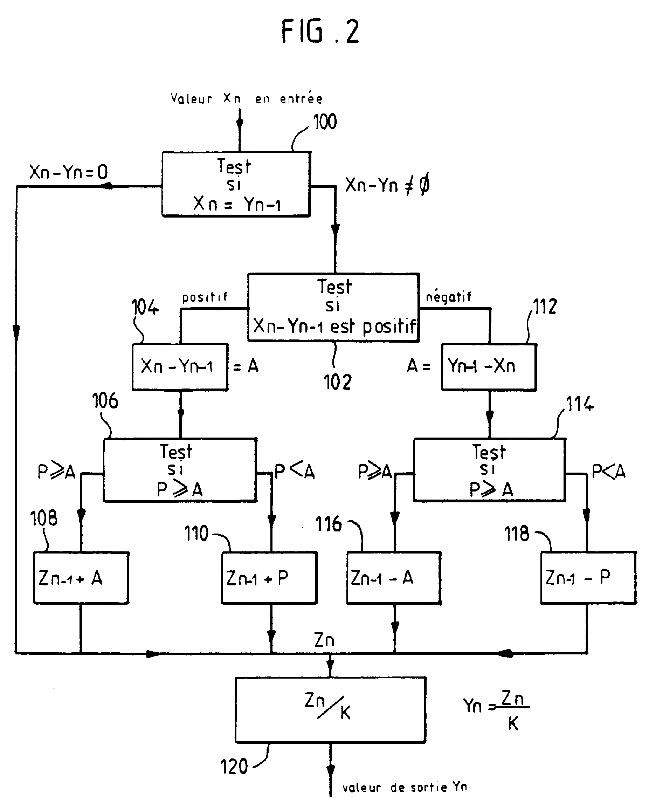

On va maintenant décrire le procédé de filtrage conforme à la présente invention en regard de la figure 2 annexée.

A chaque apparition d'une nouvelle valeur Xn en entrée, le procédé de filtrage conforme à la présente invention est initié par une étape 100 consistant à vérifier si la nouvelle valeur d'entrée Xn est ou non égale à la valeur de sortie Yn-1 antérieure.

Si le test 100 détermine que la nouvelle valeur d'entrée Xn est égale à la valeur de sortie antérieure Yn-1, cette dernière n'est pas modifiée et l'étape 100 est suivie de l'étape 120, par conséquent Yn = Yn-1.

Si par contre le test 100 détermine que la nouvelle valeur d'entrée Xn diffère de la valeur de sortie antérieure Yn-1, l'étape 100 est suivie d'une seconde étape de test 102.

Au cours de cette étape 102 le procédé détermine le signe de l'écart entre la nouvelle valeur d'entrée Xn et la valeur de sortie antérieure Yn-1.

Si l'écart entre la nouvelle valeur d'entrée Xn et l'ancienne valeur de sortie Yn-1 est positif, l'étape de test 102 est suivie de l'étape 104.

Dans le cas contraire, l'étape 102 est suivie de l'étape 112.

Au cours des étapes 104 et 112 le procédé détermine la valeur absolue de l'écart entre la nouvelle valeur d'entrée Xn et la valeur de sortie antérieure Yn-1.

Plus précisément, au cours de l'étape 104 la valeur absolue A de l'écart est obtenue en retranchant la valeur de sortie antérieure Yn-1 de la nouvelle valeur d'entrée Xn.

Inversement, au cours de l'étape 112, la valeur absolue de l'écart A est obtenue en retranchant la nouvelle valeur d'entrée Xn de la valeur de sortie antérieure Yn-1.

L'étape 104 est suivie de l'étape de test 106.

Au cours de cette étape 106 le procédé détermine si la valeur absolue de l'écart A est supérieure ou non à une valeur seuil prédéterminée P.

Si la valeur seuil prédéterminée P est supérieure ou égale à la valeur absolue de l'écart A, l'étape de test 106 est suivie de l'étape 108 au cours de laquelle le procédé calcule une nouvelle valeur de consigne Zn en ajoutant à une valeur de consigne antérieure mémorisée Zn-1, la valeur absolue de l'écart A.

En revanche, si l'étape de test 106 détermine que la valeur absolue de l'écart A est supérieure à la valeur seuil prédéterminée P, l'étape de test 106 est suivie de l'étape 110 au cours de laquelle le procédé calcule une nouvelle valeur de consigne Zn en ajoutant à la valeur de consigne antérieure mémorisée Zn-1 la valeur seuil prédéterminée P.

Les étapes 108 et 110 sont suivies de l'étape ultime 120 qui sera décrite par la suite.

L'étape 112 précédemment décrite au cours de laquelle la valeur absolue de l'écart A est déterminée et suivie d'une étape de test 114.

L'étape de test 114 est similaire à l'étape de test 106 précitée.

L'étape de test 114 sert à déterminer si la valeur absolue de l'écart est ou non supérieure à la valeur seuil prédéterminée P.

Si la valeur seuil prédéterminée est supérieure ou égale à la valeur absolue de l'écart A, l'étape 114 est suivie de l'étape 116 au cours de laquelle le procédé calcule une nouvelle valeur de consigne Zn en retranchant d'une valeur de consigne antérieure mémorisée Zn-1 la valeur absolue de l'écart A.

En revanche si lors de l'étape de test 114 le procédé détermine que la valeur absolue de l'écart A est supérieure à la valeur seuil prédéterminée P, l'étape de test 114 est suivie de l'étape 118 au cours de laquelle le procédé calcule la nouvelle valeur de consigne Zn en retranchant de la valeur de consigne antérieure Zn-1 la valeur seuil prédéterminée P.

Les deux étapes 116 et 118 sont également suivies, comme les étapes 108, 110 de l'étape 120.

Au cours de cette étape 120 le procédé calcule une valeur de sortie Yn par division de la valeur de consigne précitée Zn à l'aide d'une constante K.

K est avantageusement un entier positif compris entre 1 et 63.

Le cas échéant, la valeur de la constante K peut être modifiée en cours de fonctionnement afin de faire évoluer le temps de réponse du système.

La valeur de sortie Yn représente la déviation angulaire à appliquer sur le logomètre.

Le procédé de filtrage conforme à la présente invention permet donc de définir un signal de sortie Yn de la forme :

$$Yn = \frac{Zn}{K} =$$

$$\frac{Zn - 1 + [Sign(Xn - Yn - 1)]x[Min( Xn - Yn - 1 , P)3]}{K}$$

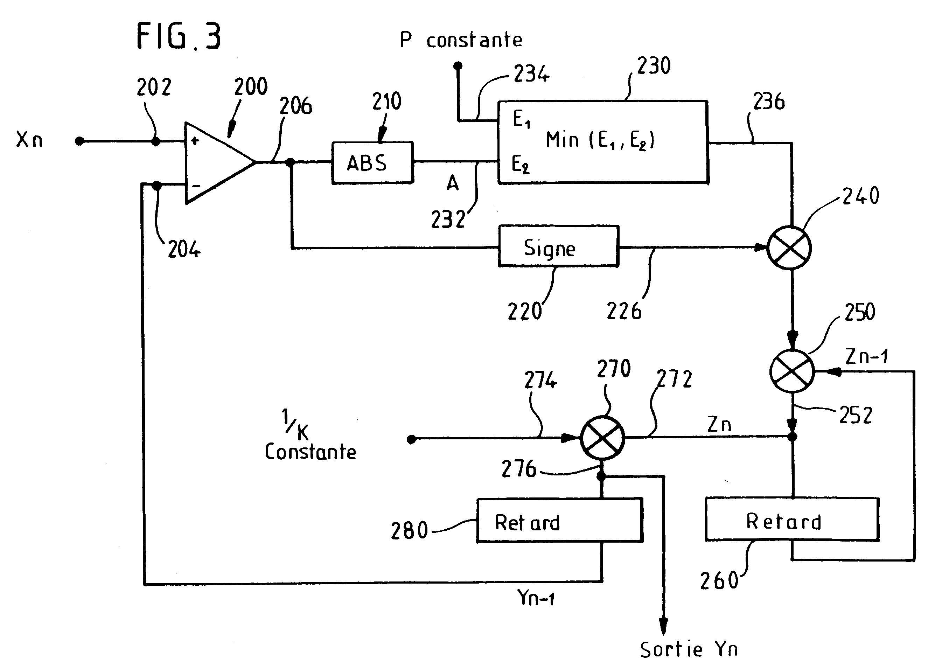

On va maintenant décrire rapidement la structure du dispositif de filtrage conforme à la présente invention représentée sous forme de bloc fonctionnel sur la figure 3 annexée et apte à mettre en oeuvre le procédé de filtrage précédemment décrit.

Selon le mode de réalisation représenté sur la figure 3 le dispositif de filtrage conforme à la présente invention comprend un étage d'entrée formé d'un comparateur 200 qui reçoit sur une première de ses entrées 202 le signal d'entrée Xn et qui reçoit sur sa seconde entrée 204 le signal de sortie antérieure Yn-1.

Le signal disponible sur la sortie 206 du comparateur 200 correspond à l'écart entre la nouvelle valeur du signal d'entrée Xn et la valeur de sortie antérieure Yn-1.

L'écart obtenu sur la sortie 206 du comparateur 200 est dirigée vers un premier module 210 déterminant la valeur absolue A de cet écart, et vers un second module 220 apte à déterminer le signe de l'écart obtenu sur la sortie 206 du comparateur 200.

Un module 230 reçoit sur ses entrées 232 et 234, respectivement la valeur absolue de l'écart A et une valeur seuil prédéterminée P constante.

Le module 230 détermine laquelle les deux valeurs A et P est minimale et applique celle-ci sur sa sortie 236.

Les sorties 226 et 236 des modules 220 et 230 sont combinées dans un élément 240 de sorte que l'on obtienne à la sortie de cet élément 240 un signal égal à celle des deux valeurs A et P qui est minimale assortie d'un signe identique à celui de l'écart en sortie du comparateur 200.

Le signal de sortie de l'élément 240 est appliqué à un additionneur 250 qui reçoit par ailleurs, par l'intermédiaire d'un retard 260, la valeur de consigne Zn-1 antérieurement mémorisée.

La valeur de consigne Zn obtenue sur la sortie 252 de l'additionneur 250 est elle-même dirigée vers une première entrée 272 d'un circuit multiplicateur 270. Le circuit multiplicateur 270 reçoit sur sa seconde entrée 274 la constante de division K. On obtient ainsi sur la sortie 276 du multiplicateur 270 la valeur de sortie Yn recherchée.

Le signal de sortie du multiplicateur 270 est par ailleurs rebouclé sur la seconde entrée 204 du comparateur 200 par l'intermédiaire d'un retard 280 pour générer la valeur de sortie antérieure à laquelle est comparée la nouvelle valeur du signal d'entrée Xn.

On notera que le dispositif et le procédé de filtrage conformes à la présente invention sont sans hystérésis. Ils requièrent un espace de mémoire restreint. Par ailleurs, ils autorisent un suivi rapide de l'aiguille de logomètre sur les grandes déviations angulaires.

Bien entendu la présente invention n'est pas limitée au mode de réalisation qui vient d'être décrit mais s'étend à toutes variantes conformes à son esprit.

**Revendications**

1. Procédé de filtrage d'un signal électrique, en particulier d'un signal de commande de logomètre pour véhicules automobiles, comprenant les étapes consistant à :
   - comparer (100) chaque nouvelle valeur reçue d'un signal d'entrée (Xn) avec une valeur de comparaison antérieure (Yn-1),
   - comparer (106, 114) l'écart (A) détecté entre ladite nouvelle valeur reçue (Xn) du signal d'entrée et la valeur de comparaison antérieure (Yn-1), avec une valeur seuil prédéterminée (P),
   - mémoriser une valeur de consigne (Zn),
   - rafraîchir la valeur de consigne mémorisée (Zn) en modifiant la valeur de consigne antérieure (Zn-1) de la valeur de seuil prédéterminée (P) si ladite valeur de seuil prédéterminée (P) est inférieure audit écart détecté (A), ou en modifiant la valeur de consigne antérieure (Zn-1) dudit écart détecté (A), si ladite valeur seuil prédéterminée (P) est supérieure audit écart détecté (A), et
   - diviser (120) la valeur de consigne mémorisée (Zn) par une constante (K) pour former le signal de sortie (Yn), caractérisé par le fait que la valeur de comparaison antérieure est égale à la valeur du signal de sortie antérieur.

2. Procédé selon la revendication 1, caractérisé par le fait qu'il comprend en outre l'étape consistant à reconnaître (102) le sens de l'écart détecté entre ladite nouvelle valeur reçue du signal d'entrée (Xn) et la valeur de sortie antérieure (Yn-1).

3. Procédé selon la revendication 2, caractérisé par le fait que l'étape (108, 110, 116, 118) consistant à rafraîchir la valeur de consigne mémorisée (Zn) est obtenue en additionnant la valeur seuil prédéterminée (P) ou la valeur absolue de l'écart détecté (A) à la valeur de consigne antérieure (Zn) si l'écart détecté est positif, et est obtenue en soustrayant la valeur seuil prédéterminée (P) ou la valeur absolue de l'écart détecté (A) de la valeur de consigne antérieure (Zn-1) si l'écart détecté est négatif.

4. Procédé selon l'une des revendications 1 à 3, caractérisé par le fait que la constante (K) utilisée au cours de l'étape de division est un entier positif, de préférence compris entre 1 et 63.

5. Procédé selon l'une des revendications 1 à 4, caractérisé par le fait que la constante (K) utilisée au cours de l'étape de division peut être modifiée au cours du fonctionnement.

6. Dispositif de filtrage de signaux électriques, en particulier de signaux de commande de logomètre, comprenant :
   - des moyens (200) aptes à comparer chaque nouvelle valeur reçue d'un signal d'entrée (Xn) à une valeur de comparaison antérieure (Yn-1),
   - des moyens (230) aptes à comparer l'écart détecté entre ladite nouvelle valeur reçue du signal d'entrée (Xn) et la valeur de comparaison antérieure (Yn-1), avec une valeur seuil prédéterminée (P),
   - des moyens de mémoire aptes à mémoriser une valeur de consigne (Zn),
   - des moyens (250) aptes à rafraîchir la valeur de consigne mémorisée (Zn)
     . en modifiant la valeur de consigne antérieure (Zn-1) de la valeur seuil prédéterminée (P), si ladite valeur seuil prédéterminée est inférieure audit écart détecté (A), ou
     . en modifiant la valeur de consigne antérieure (Zn-1) dudit écart détecté (A), si ladite valeur seuil prédéterminée (P) est supérieure audit écart détecté (A), et
   - des moyens (270) aptes à diviser la valeur de consigne mémorisée (Zn) par une constante (K) pour former le signal de sortie (Yn), caractérisé par le fait que la valeur de comparaison antérieure est égale à la valeur du signal de sortie antérieure.

7. Dispositif selon la revendication 6, caractérisé par le fait qu'il comprend en outre des moyens (220) aptes à reconnaître le sens de l'écart détecté entre la nouvelle valeur reçue du signal d'entrée (Xn) et la valeur de sortie antérieure (Yn-1).

8. Dispositif selon la revendication 7, caractérisé par le fait que les moyens aptes à rafraîchir la valeur de consigne mémorisée (Zn) sont conçus pour ajouter la valeur seuil prédéterminée (P) ou la valeur absolue de l'écart détecté (A) à la valeur de consigne antérieure (Zn-1) si ledit écart détecté est positif et pour retrancher la valeur seuil prédéterminée (P) ou la valeur absolue de l'écart détecté (A) à la valeur de consigne antérieure (Zn-1) si l'écart détecté est négatif.

9. Dispositif selon l'une des revendications 1 à 8, caractérisé par le fait que la constante utilisée par les moyens de division (270) est un entier positif de préférence compris entre 1 et 5.

**Patentansprüche**

1. Verfahren zum Filtern eines elektrischen Signals, insbesondere eines Steuersignals eines Quotientenmessinstrumentes für Kraftfahrzeuge, welches die folgende Schritte umfaßt:
   - Vergleichen (100) jedes neuen Empfangswertes eines Eingangssignals (Xn) mit einem vorhergehenden Vergleichswert (Yn-1),
   - Vergleichen (106, 114) des erfassten Unterschiedes (A) zwischen dem genannten neuen Empfangswert (Xn) des Eingangssignals und dem vorhergehenden Vergleichswert (Yn-1) mit einem bestimmten Schwellenwert (P),
   - Speichern eines Einstellwertes (Zn),
   - Erneuern des gespeicherten Einstellwertes (Zn) durch Modifizieren des vorhergehenden Einstellwertes (Zn-1) mit dem bestimmten Schwellenwert (P), wenn dieser bestimmte Schwellenwert (P) kleiner als der erfasste Unterschied (A) ist, oder durch Modifizieren des vorhergehenden Einstellwertes (Zn-1) mit dem erfassten Unterschied (A), wenn der bestimmte Schwellenwert (P) über dem erfassten Unterschied (A) liegt, und
   - Teilen (120) des gespeicherten Einstellwertes (Zn) durch eine Konstante (K) zum Bilden des Ausgangssignals (Yn), dadurch gekennzeichnet, daß der vorhergehende Vergleichswert gleich einem Wert des vorhergehenden Ausgangssignals ist.

2. Verfahren nach Anspruch 1, dadurch gekennzeichnet, daß es einen weiteren Schritt umfaßt, der im Erkennen (102) der Richtung des erfassten Unterschiedes zwischen dem neuen Empfangswert des Eingangssignals (Xn) und dem vorhergehenden Ausgangswert (Yn-1) besteht.

3. Verfahren nach Anspruch 2, dadurch gekennzeichnet, daß der Schritt (108, 110, 116, 118) der darin besteht, den gespeicherten Einstellwert (Zn) zu erneuern, dadurch ausgeführt wird, daß der vorbestimmte Schwellenwert (P) oder der Absolutwert des erfassten Unterschiedes (A) dem vorhergehenden Einstellwert (Zn-1) zuaddiert wird, wenn der erfasste Unterschied positiv ist, und dadurch ausgeführt wird, daß der bestimmte Schwellenwert (P) oder der Absolutwert des erfassten Unterschiedes (A) vom vorhergehenden Einstellwert (Zn-1) abgezogen wird, wenn der erfasste Unterschied negativ ist.

4. Verfahren nach einem der Ansprüche 1 bis 3 dadurch gekennzeichnet, daß die Konstante (K), die beim Schritt der Teilung verwandt wird, eine positive ganze Zahl vorzugsweise zwischen 1 und 63 ist.

5. Verfahren nach einem der Ansprüch 1 bis 4, dadurch gekennzeichnet, daß die Konstante (K), die beim Schritt der Teilung verwandt wird, während des Verfahrensablaufes modifiziert werden kann.

6. Vorrichtung zum Filtern von elektrischen Signalen insbesondere von Steuersignalen eines Quotientenmessinstrumentes mit
   - Einrichtungen (200), die jeden neuen Empfangswert eines Eingangssignals (Xn) mit einem vorhergehenden Vergleichswert (Yn-1) vergleichen können,
   - Einrichtungen (230), die den erfassten Unterschied zwischen dem neuen Empfangswert des Eingangssignals (Xn) und dem vorhergehenden Vergleichswert (Yn-1) mit einem bestimmten Schwellenwert (P) vergleichen können,
   - Speichereinrichtungen, die einen Einstellwert (Zn) speichern können,
   - Einrichtungen (250), die den gespeicherten Einstellwert (Zn) erneuern können, indem sie
   den vorhergehenden Einstellwert (Zn-1) mit dem vorbestimmten Schwellenwert (P) modifizieren, wenn dieser bestimmte Schwellenwert kleiner als der erfaßte Unterschied (A) ist, oder indem sie den vorhergehenden Einstellwert (Zn-1) mit dem erfaßten Unterschied (A) modifizieren, wenn der bestimmte Schwellenwert (P) größer als der erfaßte Unterschied (A) ist, und
   - Einrichtungen (270), die den gespeicherten Einstellwert (Zn) durch eine Konstante (K) teilen können, um das Ausgangssignal (Yn) zu bilden, dadurch gekennzeichnet, daß der vorhergehende Vergleichswert gleich dem Wert des vorhergehenden Ausgangssignals ist.

7. Vorrichtung nach Anspruch 6, dadurch gekennzeichnet, daß sie weiterhin Einrichtungen (220) umfaßt, die die Richtung des erfassten Unterschiedes zwischen dem neuen Empfangswert des Eingangssignals (Xn) und dem vorhergehenden Ausgangswert (Yn-1) erkennen können.

8. Vorrichtung nach Anspruch 7, dadurch gekennzeichnet, daß die Einrichtungen, die den gespeicherten Einstellwert (Zn) erneuern können, so ausgebildet sind, daß sie den bestimmten Schwellenwert (P) oder den Absolutwert des erfaßten Unterschiedes (A) zum vorhergehenden Einstellwert (Zn-1) addieren, wenn der erfaßte Unterschied positiv ist, und den bestimmten Schwellenwert (P) oder den Absolutwert des erfaßten Unterschiedes (A) vom vorhergehenden Einstellwert (Zn-1) abziehen, wenn der erfaßte Unterschied negativ ist.

9. Vorrichtung nach einem der Ansprüche 1 bis 8, dadurch gekennzeichnet, daß die Konstante, die von den Einrichtungen zum Teilen (270) verwandt wird, eine positive ganze Zahl vorzugsweise zwischen 1 und 5 ist.

**Claims**

1. A method of filtering an electrical signal, in particular a control signal for a motor vehicle ratio meter, the method comprising the following steps:

    comparing (100) each new received value of an input signal (Xn) with a previous comparison value (Yn-1);

    comparing (106, 114) the difference (A) detected between said new received value (Xn) of the input signal and the previous comparison value (Yn-1) with a predetermined threshold value (P);

    storing a reference value (Zn);

    refreshing the stored reference value (Zn) by modifying the previous reference value (Zn-1) by the predetermined threshold value (P) if said predetermined threshold value (P) is smaller than said detected difference (A), or by modifying the previous reference value (Zn-1) by said detected difference (A) if said predetermined threshold value (P) is greater than said detected difference (A); and

    dividing (120) the stored reference value (Zn) by a constant (K) to form the output signal (Yn), the method being characterized by the fact that the previous comparison value is equal to the value of the previous output signal.

2. A method according to claim 1, characterized by the fact that it further includes the step in recognizing (102) the sense of the detected difference between the new received value of the input signal (Xn) and the previous output value (Yn-1).

3. A method according to claim 2, characterized by the fact that the step (108, 110, 116, 118) consisting in refreshing the stored reference value (Zn) is obtained by adding the predetermined threshold value (P) or the absolute value of the detected difference (A) to the previous reference value (Zn) if the detected difference is positive, and is obtained by subtracting the predetermined threshold value (P) or the absolute value of the detected difference (A) from the previous reference value (Zn-1) if the detected difference is negative.

4. A method according to any one of claims 1 to 3, characterized by the fact that the constant (K) used during the division step is a positive integer, preferably lying in the range 1 to 63.

5. A method according to any one of claims 1 to 4, characterized by the fact that the constant (K) used during the division step can be modified during operation.

6. Apparatus for filtering electrical signals, in particular ratio meter control signals, the apparatus comprising:

    means (200) suitable for comparing each new received value of an input signal (Xn) with a previous comparison value (Yn-1);

    means (230) suitable for comparing the difference detected between said new received value of the input signal (Xn) and the previous comparison value (Yn-1) with a predetermined threshold value (P);

    memory means suitable for storing a reference value (Zn) ;

    means (250) suitable for refreshing the stored reference value (Zn);

    by modifying the previous reference value (Zn-1) by means of the predetermined threshold value (P) if said predetermined threshold value is less than said detected difference (A); or

    by modifying the previous reference value (Zn-1) by means of said detected difference (A) if said predetermined threshold value (P) is greater than said detected difference (A); and

    means (270) suitable for dividing the memorized reference value (Zn) by a constant (K) to form the output signal (Yn), the apparatus being characterized by the fact that the previous comparison value is equal to the value of the previous output signal.

7. Apparatus according to claim 6, characterized by the fact that it further includes means (220) suitable for recognizing the sense of the difference detected between the new received value of the input signal (Yn) and the previous output value (Yn-1).

8. Apparatus according to claim 7, characterized by the fact that the means suitable for refreshing the stored reference value (Zn) are designed to add the predetermined threshold value (P) or the absolute value of the detected difference (A) to the previous reference value (Zn-1) if said detected difference is positive, and to subtract the predetermined threshold value (P) or the absolute value of the detected difference (A) from the previous reference value (Zn-1) if the detected difference is negative.

9. Apparatus according to any one of claims 1 to 8, characterized by the fact that the constant used by the division means (270) is a positive integer and preferably lies in the range 1 to 5.

Fréquence    d'horloge

Signal d'entrée
en fréquence

Compteur   (Périodemètre)

10

Programmation

Xn

Filtrage

20

Yn

Table   de   codage
Interpolation

30

Génération   des   Rapports
cycliques

Logique   de   sortie

40

1

2

Sortie
Bobine

Sortie
Bobine

FIG.1

# FIG.2

Valeur Xn en entrée

```
                              ┌─────────────┐  100
   Xn-Yn=0                    │    Test     │
  ◄──────────────────────────│     si      │────► Xn-Yn ≠ ∅
                              │  Xn = Yn-1  │
                              └─────────────┘
                                     │
                                     ▼
                              ┌──────────────────────┐
         positif             │        Test          │   négatif
  104  ◄─────────────────────│         si           │─────────────────►  112
                              │  Xn-Yn-1 est positif │
   ┌──────────────┐           └──────────────────────┘         ┌──────────────┐
   │ Xn - Yn-1 = A│                    102                      │ A = Yn-1 -Xn │
   └──────────────┘                                             └──────────────┘
          │                                                            │
  106     ▼                                                     114    ▼
   ┌──────────────┐                                             ┌──────────────┐
   │     Test     │                                             │     Test     │
 P≥A◄──│      si      │──►P<A                              P≥A◄──│      si      │──►P<A
   │    P ≥ A     │                                             │    P ≥ A     │
   └──────────────┘                                             └──────────────┘
```

| 108 | 110 | 116 | 118 |
|---|---|---|---|
| $Z_{n-1} + A$ | $Z_{n-1} + P$ | $Z_{n-1} - A$ | $Z_{n-1} - P$ |

Zn

$$Y_n = \frac{Z_n}{K}$$

$$Z_n / K$$

120

valeur de sortie Yn

FIG.3

Xn

200

202

204

206

210 ABS

P constante

234

230 $Min (E_1, E_2)$  $E_1$  $E_2$

A

232

236

240

220 Signe

226

250

$Z_{n-1}$

252

Retard

260

$Z_n$

272

270

274

276

$1/K$ Constante

280 Retard

$Y_{n-1}$

Sortie Yn